# EUROPEAN PATENT SPECIFICATION

(11) **EP 3 893 381 B1**
(45) Date of publication and mention of the grant of the patent: **26.10.2022**
(21) Application number: 21167593.9
(22) Date of filing: 09.04.2021
(51) Int. Cl.: H02P 1/04, H02P 27/08

(54) **METHOD OF DYNAMICALLY CONTROLLING MINIMUM DUTY CYCLE AND RELATED HALF-BRIDGE BOOTSTRAP CIRCUIT**
VERFAHREN ZUR DYNAMISCHEN REGELUNG DER MINIMALEN EINSCHALTDAUER UND ZUGEHÖRIGE HALBBRÜCKEN-BOOTSTRAP-SCHALTUNG
PROCÉDÉ DE COMMANDE DYNAMIQUE D'UN RAPPORT CICLIQUE MINIMAL ET CIRCUIT D'AMORÇAGE EN DEMI-PONT ASSOCIÉ

(30) Priority: 12.04.2020 US 202063008823 P; 04.01.2021 TW 110100008
(43) Date of publication of application: 13.10.2021
(73) Proprietor: LSC Ecosystem Corporation, Taoyuan City 333 (TW)
(72) Inventor: Wang, Chang-Ming, Taipei City 116 (TW); Cheng, Tsung-Tai, Taoyuan City 338 (TW); Wang, Hsiao-Wu, Hualien County 971 (TW)
(74) Representative: Straus, Alexander

(56) References cited:
- EP-A2- 0 973 250
- CN-A- 103 368 362
- US-A- 5 659 452

## Description

### Field of the Invention

The present invention is related to a method of dynamically controlling minimum duty cycle and related half-bridge bootstrap circuit according to different operational phases of a load.

### Background of the Invention

An electric motor is an electrical machine that converts electrical energy into mechanical energy. There are various types of motors, including direct-current (DC) motors, alternating-current (AC) motor and stepper motors. One simple and easy way to control the speed and energy consumption of a motor is to regulate the amount of current flowing through its terminals using a pulse width modulation (PWM) technique. As its name suggests, the PWM speed control works by driving the motor with a series of high-frequency "ON-OFF" pulses and varying the duty cycle, the fraction of time that the output voltage is "ON" compared to when it is "OFF", of the pulses while keeping the frequency constant.

A half-bridge bootstrap circuit is normally used to drive a motor and includes a boot capacitor, a high-side switch, and a low-side switch. The high-side switch and the low-side switch are coupled between a bus voltage and a ground voltage in a totem pole configuration, wherein the coupling point of the high-side switch and the low-side switch serves as an output end. When the high-side switch is turned off and the low-side switch is turned on, the DC voltage may charge the boot capacitor. When the high-side switch is turned on and the low-side switch is turned off, the energy stored in the boot capacitor may keep the high-side switch turned on, thereby transmitting the bus voltage to the output end for providing an output voltage.

In order to ensure that sufficient charges are stored in the boot capacitor for keeping the high-side switch turned on, a minimum duty (MD) scheme is normally adopted for limiting the minimum turn-on time of the low-side switch. The prior art half-bridge bootstrap circuit controls the low-side switch according to a constant minimum duty cycle curve, which also limits the maximum power of the motor as the power of the motor increases. Therefore, there is a need for a half-bridge bootstrap circuit capable of dynamically controlling minimum duty cycle.

CN103368362A teaches a driving circuit of a dual-power field-effect tube under half-bridge configuration. The driving circuit can be used for driving first and second power transistors alternatively, and includes a breakdown reducing circuit which is used for monitoring the grid source voltages of the two power transistors so as to restrain the breakover of one of power transistors till the grid source voltage of the other power transistor is switched to a low level, namely, the other transistor is in an off state. Moreover, the driving circuit includes a circuit which is used for preventing instantaneous signals transmitted by the power transistors since the running of the driving circuit can be influenced by the instantaneous signals.

EP 0973250A2 teaches a pulse width modulation amplifier of the type including power transistors connected in totem pole fashion and a bootstrap capacitor used to bias at least one of the power transistors into the conductive state. In the improvement, the bootstrap capacitor is refreshed only to the extent needed to provide a higher effective maximum duty cycle.

US 5659452A teaches a method of operating a switched reluctance machine, which provides electrical current overload protection. The stator winding motor drive employs a high-side semiconductor switch, along with a corresponding high-side gate driver (which incorporates a bootstrap-type drive circuit). A low-side semiconductor switch and a corresponding gate driver are also used to thereby define a two-switch per phase topology. The high-side MOSFET switch gate driver must have rising and falling edges from an associated controller in order for the bootstrap drive power supply portion to function. A drive controller is configured so that it will generate these rising and falling edges only when the motor is moving, as indicated by a speed signal. Therefore, if the motor stops moving, due to an unexpected load, such as a seized pump connected to an output shaft thereof, the speed signal will so indicate the stall, wherein the controller will not generate a signal having rising and falling edges. A bootstrap capacitor in the bootstrap drive circuit will slowly discharge in the absence of pulses from the controller. Once discharged to a predetermined level, the drive circuit will no longer be able to cause the high-side semiconductor switch to conduct, thus breaking the circuit, and interrupting current flow through the stator winding.

### Summary of the Invention

The present invention is related to a method of dynamically controlling minimum duty cycle and related half-bridge bootstrap circuit according to different operational phases of a load.

This is achieved by a method of dynamically controlling minimum duty cycle according to independent method 1 and a half-bridge bootstrap circuit according to independent apparatus claim 11.

The dependent claims pertain to corresponding further developments and improvements.

As will be seen more clearly from the detailed description following below, the claimed method of dynamically controlling minimum duty cycle includes turning off a high-side switch and turning on a low-side switch during a charging period for allowing a DC voltage to charge a capacitor; turning on the high-side switch and turning off the low-side switch during a discharging period subsequent to the charging period for allowing energy stored in the capacitor to charge parasite capacitance of the high-side switch, thereby keeping the high-side switch turned on and allowing a bus voltage to be transmitted to an output end for driving a motor; adjusting a first turn-on time of the high-side switch during the discharging period according to a status of the output end; and limiting a second turn-on time of the low-side switch during the charging period according to a dynamically controlled minimum duty cycle curve. The value of the dynamically controlled minimum duty cycle curve is not larger than a maximum value when a rotational speed of the motor is not larger than a first rotational speed. The value of the dynamically controlled minimum duty cycle curve is equal to the maximum value when the rotational speed of the motor is equal to the first rotational speed. The value of the dynamically controlled minimum duty cycle curve is not larger than the maximum value when the rotational speed of the motor is greater than the first rotational speed.

As will be seen more clearly from the detailed description following below, the claimed half-bridge bootstrap circuit which dynamically controls minimum duty cycle includes an output end for providing an output voltage to drive a motor, a high-side switch configured to selectively conduct a signal path between a bus voltage and the output end, a low-side switch configured to selectively conduct a signal path between the output end and a ground voltage, a capacitor having a first end selectively coupled to a DC voltage and a second end selectively coupled to the output end, and a control circuit. The control circuit is configured to turn off the high-side switch and turn on the low-side switch during a charging period for coupling the output end to the ground voltage and allowing the DC voltage to charge the capacitor; turn on the high-side switch and turn off the low-side switch during a discharging period subsequent to the charging period for coupling the output end to the bus voltage and allowing energy stored in the capacitor to charge parasite capacitance of the high-side switch, thereby keeping the high-side switch turned on; adjust a first turn-on time of the high-side switch during the discharging period according to a status of the output end; and limit a second turn-on time of the low-side switch during the charging period according to a dynamically controlled minimum duty cycle curve. A value of the dynamically controlled minimum duty cycle curve is not larger than a maximum value when a rotational speed of the motor is not larger than a first rotational speed. The value of the dynamically controlled minimum duty cycle curve is equal to the maximum value when the rotational speed of the motor is equal to the first rotational speed. The value of the dynamically controlled minimum duty cycle curve is not larger than the maximum value when the rotational speed of the motor is larger than a first rotational speed and smaller than a second rotational speed which is larger than the first rotational speed; and the value of the dynamically controlled minimum duty cycle curve is zero when the rotational speed of the motor is larger than the second rotational speed.

### Brief Description of the Drawings

In the following, the invention is further illustrated by way of example, taking reference to the accompanying drawings.
FIG. 1 is a diagram illustrating a half-bridge bootstrap circuit capable of dynamically controlling minimum duty cycle according an embodiment of the present invention;
FIG. 2 is a signal diagram illustrating the operation of the control circuit in a half-bridge bootstrap circuit according an embodiment of the present invention;
FIG. 3 is a characteristic diagram illustrating the operation of a motor driven by a half-bridge bootstrap circuit according an embodiment of the present invention; and
FIG. 4 is a diagram illustrating the operation of dynamically controlling minimum duty cycle in a half-bridge bootstrap circuit according an embodiment of the present invention.

### Detailed Description

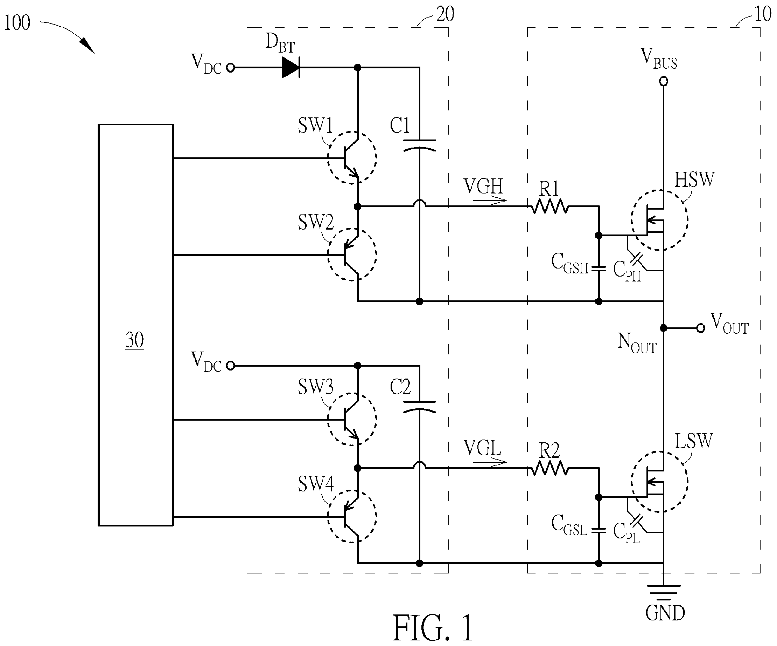

FIG. 1 is a diagram illustrating a half-bridge bootstrap circuit 100 capable of dynamically controlling minimum duty cycle according an embodiment of the present invention. The half-bridge bootstrap circuit 100 includes a power device 10, a driving output circuit 20, and a control circuit 30. The half-bridge bootstrap circuit 100 is configured to provide an output voltage V_{OUT} at an output end N_{OUT} for driving a load (not shown in FIG. 1).

The power device 10 includes a high-side switch HSW, a low-side switch LSW, resistors R1 and R2, and capacitors C_{GSH} and C_{GSL}. The high-side switch HSW includes a first end coupled to a bus voltage V_{BUS}, a second end coupled to the output end N_{OUT}, and a control end coupled to the driving output circuit 20 via the resistor R1 for receiving a control signal VGH. The low-side switch LSW includes a first end coupled to the output end N_{OUT}, a second end coupled to the ground voltage GND, and a control end coupled to the driving output circuit 20 via the resistor R2 for receiving a control signal VGL. C_{PH} represents the parasite capacitance between the control end and the second end of the high-side switch HSW, and C_{PL} represents the parasite capacitance between the control end and the second end of the low-side switch LSW. The capacitor C_{GSH} is coupled in parallel with the parasite capacitance C_{PH} of the high-side switch HSW, and configured to prevent the malfunction of the high-side switch HSW and adjust the switching speed of the high-side switch HSW. The capacitor C_{GSL} is coupled in parallel with the parasite capacitance C_{PL} of the low-side switch LSW, and configured to prevent the malfunction of the low-side switch LSW and adjust the switching speed of the low-side switch LSW.

The driving output circuit 20 includes switches SW1-SW4, capacitors C1-C2, and a boot diode D_{BT}. The boot diode D_{BT} includes an anode coupled to a DC voltage V_{DC} and a cathode coupled to the output end N_{OUT} via the capacitor C1. The switch SW1 includes a first end coupled to cathode of the boot diode D_{BT}, a second end coupled to the resistor R1 of the power device 10, and a control end coupled to the control circuit 30. The switch SW2 includes a first end coupled to second end of the switch SW1, a second end coupled to the output end N_{OUT}, and a control end coupled to the control circuit 30. The switch SW3 includes a first end coupled to the DC voltage V_{DC}, a second end coupled to the resistor R2 of the power device 10, and a control end coupled to the control circuit 30. The switch SW4 includes a first end coupled to the second end of the switch SW3, a second end coupled to the ground voltage GND, and a control end coupled to the control circuit 30. The capacitor C1 is a boot capacitor and includes a first end coupled to the DC voltage V_{DC} via the boot diode D_{BT}, and a second end coupled to the output end N_{OUT}. The capacitor C2 includes a first end coupled to the DC voltage V_{DC} and a second end coupled to the ground voltage GND.

The control circuit is configured to control the operation of the switches SW1-SW4 according to the status of the output end N_{OUT} for providing the control signals VGH and VGL, thereby selectively turning on/off the high-side switch HSW and the low-side switch LSW so that the half-bridge bootstrap circuit 100 may alternatively operate in charging periods and discharging periods.

During each charging period of the half-bridge bootstrap circuit 100, the control circuit 30 is configured to control the switches SW1-SW4 of the driving output circuit 20 to output a control signal VGH having a disable level and a control signal VGL having an enable level, thereby turning off the high-side switch HSW and turning on the low-side switch LSW. Under such circumstance, the output end N_{OUT} may be coupled to the ground voltage GND via the turned-on switch SW2, and the DC voltage V_{DC} may charge the capacitor C1 via the forward-biased boot diode D_{BT}. In other words, the amount of energy stored in the capacitor C1 during each charging period is determined by the turn-on time of the low-side switch LSW.

During each discharging period of the half-bridge bootstrap circuit 100, the control circuit 30 is configured to control the switches SW1-SW4 of the driving output circuit 20 to output a control signal VGH having an enable level and a control signal VGL having a disable level, thereby turning on the high-side switch HSW and turning off the low-side switch LSW. Under such circumstance, the output end N_{OUT} may be coupled to the bus voltage V_{BUS} via the turned-on high-side switch HSW, and the reverse-biased boot diode D_{BT} is turned off. Meanwhile, the energy stored in the capacitor C1 during the charging period may charge the parasite capacitance C_{PH} of the high-side switch HSW, thereby keeping the high-side switch HSW turned on. Also, the bus voltage V_{BUS} may be transmitted to the output end N_{OUT} via the turned-on high-side switch HSW for providing the output voltage V_{OUT}. In other words, the value of the output voltage V_{OUT} is determined by the turn-on time of the high-side switch HSW during each discharging period.

Motors are normally driven using sinusoid waves. In motor driving applications, the half-bridge bootstrap circuit 100 of the present invention is configured to provide the output voltage V_{OUT} as sinusoidal wave having various frequencies and peaks so as to create magnetic field inside the motor, thereby controlling the rotational speed of the motor. As well-known to those skilled in the art, a motor can rotate in the forward direction or backward direction. The direction of motor rotation may be altered by changing the polarity of the input voltages, the phase sequence of the input voltages or the signal commands in different applications (such as for a DC motor, an AC motor or a stepper motor). For ease of explanation, a single direction of motor rotation is used to illustrate the present invention in subsequent paragraphs. The present invention can also be applied to the other direction of motor rotation similarly.

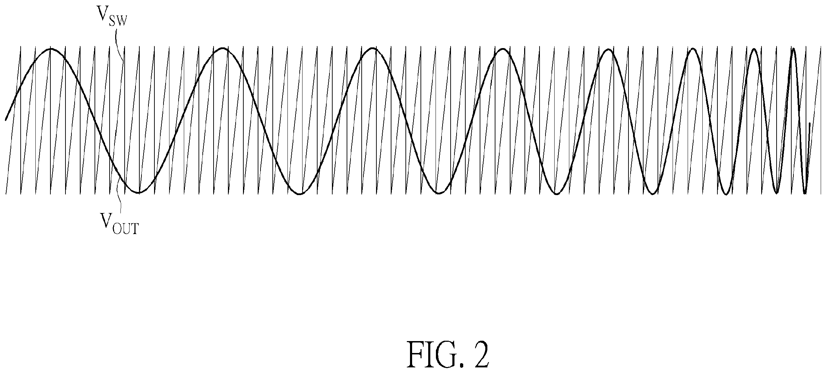

FIG. 2 is a signal diagram illustrating the operation of the control circuit 30 in the half-bridge bootstrap circuit 100 according an embodiment of the present invention. The control circuit 30 is configured to control the turn-on time and the turn-off time of the high-side switch HSW and the low-side switch LSW according to the frequency of the output voltage V_{OUT} and the frequency of a switching voltage Vsw. The switching voltage Vsw is a pulse signal having a constant frequency and a constant peak. The frequency and the peak of the output voltage V_{OUT} are associated with the output power of the half-bridge bootstrap circuit 100. In the application of motor driving, the frequency and the peak of the output voltage V_{OUT} are associated with the rotational speed of the motor. In order to ensure the integrity of the waveform of the output voltage V_{OUT}, the frequency of the switching voltage Vsw is usually larger than the frequency of the output voltage V_{OUT} by at least five times. For illustrative purpose in FIG. 2, the frequency of the output voltage V_{OUT} gradually increases, and the peaks of the switching voltage Vsw and the output voltage V_{OUT} have the same value.

When the level of the switching voltage Vsw is higher than the level of the output voltage V_{OUT}, the control circuit 30 is configured to control the driving output circuit 20 for turning off the high-side switch HSW and turning on the low-side switch LSW. When the level of the switching voltage Vsw is lower than the level of the output voltage V_{OUT}, the control circuit 30 is configured to control the driving output circuit 20 for turning on the high-side switch HSW and turning off the low-side switch LSW. As depicted in FIG. 2, a larger peak of the output voltage V_{OUT} results in a longer turn-on time of the high-side switch HSW, and a smaller peak of the output voltage V_{OUT} results in a shorter turn-on time of the high-side switch HSW. On the other hand, a lower frequency of the output voltage V_{OUT} results in a longer turn-on time and more frequent switching of the high-side switch HSW.

In order to ensure that sufficient charges are stored in the capacitor C1 during the discharging period for keeping the high-side switch HSW turned on, the control circuit 30 of the present invention is configured to limit the minimum turn-on time of the low-side switch LSW during the charging period according to a dynamically controlled minimum duty cycle curve, i.e., allowing sufficient charges to be stored in the capacitor C1 during the charging period. More specifically, if the control signal VGL is kept at the enable level for a period which is not smaller than the turn-on time of the dynamically controlled minimum duty cycle curve, a maximized power output may be provided.

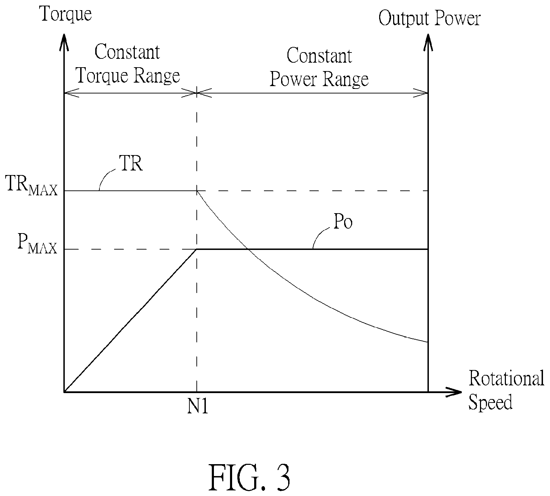

FIG. 3 is a characteristic diagram illustrating the operation of a motor driven by the half-bridge bootstrap circuit 100 according an embodiment of the present invention. The horizontal axis represents the rotational speed of the motor. The left-side vertical axis represents the torque of the motor. The right-side vertical axis represents the output power of the motor. TR represents the curve showing the relationship between the torque and the rotational speed of the motor. Po represents the curve showing the relationship between the output power and the rotational speed of the motor, wherein the output power Po is substantially equal to a product of the torque and the rotational speed of the motor. The range before the rotational speed of the motor reaches a threshold rotational speed N1 is called the constant torque range. The range after the rotational speed of the motor reaches the threshold rotational speed N1 is called the constant power range. When the rotational speed of the motor is within the constant torque range, the torque TR of the motor is kept at a constant maximum torque TR_{MAX}. When the rotational speed of the motor is within the constant power range (after the rotational speed of the motor reaches the threshold rotational speed N1), the torque TR of the motor decreases as the rotational speed of the motor increases, and the output power Po of the motor is kept at a constant maximum output power PR_{MAX}. The value of the threshold rotational speed N1 is associated with the bus voltage V_{BUS}, wherein a larger bus voltage V_{BUS} results in a larger threshold rotational speed N1.

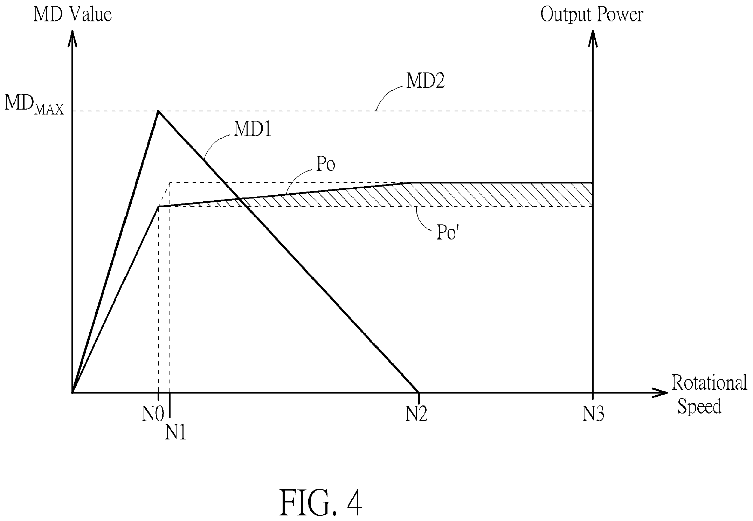

FIG. 4 is a diagram illustrating the operation of dynamically controlling minimum duty cycle in the half-bridge bootstrap circuit 100 according an embodiment of the present invention. The horizontal axis represents the rotational speed of the motor. The left-side vertical axis represents the MD values of the minimum duty cycle curves. The right-side vertical axis represents the output power of the motor. MD1 represents one embodiment of the dynamically controlled minimum duty cycle curve adopted by the half-bridge bootstrap circuit 100 of the present invention. MD2 represents a constant minimum duty cycle curve adopted by a prior art half-bridge bootstrap circuit. Po represents the curve showing the relationship between the output power and the torque of the motor driven by the half-bridge bootstrap circuit 100 of the present invention. Po' represents the curve showing the relationship between the output power and the rotational speed of the motor driven by the prior art half-bridge bootstrap circuit. As depicted in FIGs. 3 and 4, when the half-bridge bootstrap circuit 100 of the present invention is used to drive the motor, different operational phases of the motor require different MD values. Therefore, the control circuit 30 in the half-bridge bootstrap circuit 100 of the present invention is configured to adopt the dynamically controlled minimum duty cycle curve MD1 whose maximum value is equal to MD_{MAX}.

When the rotational speed of the motor is smaller than the threshold rotational speed N1, the output power of the motor has not reached the constant power range and the peak of the corresponding output voltage V_{OUT} is smaller than the peak of the switching signal Wsw, which allows the low-side switch LSW to have a longer turn-on time for the capacitor C1 to be sufficiently charged. Under such circumstance, the dynamically controlled minimum duty cycle curve MD1 may have any value smaller than the maximum value MD_{MAX}. When the rotational speed of the motor is between 0 and N0, the dynamically controlled minimum duty cycle curve MD1 has not been able to effectively limit the output power of the motor, and the output power Po of the motor increases with its rotational speed. When the rotational speed of the motor approaches the threshold rotational speed N1 and reaches N0, the dynamically controlled minimum duty cycle curve MD1 is able to effectively limit the output power Po of the motor so that the limitation of the constant power range is reached in advance, wherein the difference between N0 and N1 is determined by the setting of the dynamically controlled minimum duty cycle curve MD1. In the embodiment illustrated in FIG. 4, when the rotational speed of the motor is smaller than the threshold rotational speed N1, the value of the dynamically controlled minimum duty cycle curve MD1 increases in a linear manner as the rotational speed of the motor increases. In another embodiment when the rotational speed of the motor is smaller than the threshold rotational speed N1, the value of the dynamically controlled minimum duty cycle curve MD1 increases in a polynomial manner, an exponential manner or a stepwise manner as the rotational speed of the motor increases.

When the rotational speed of the motor reaches the threshold rotational speed N1, the output power Po of the motor reaches the limitation of the constant power range, and the peak of the corresponding output voltage V_{OUT} is substantially equal to the peak of the switching signal Vsw, which shortens the turn-on time of the low-side switch LSW. In order to ensure that sufficient charges are stored in the capacitor C1 during the shorter turn-on time of the low-side switch LSW for keeping the high-side switch HSW turned on during the subsequent period, the dynamically controlled minimum duty cycle curve MD1 is set to the maximum value MD_{MAX}. Since the value the threshold rotational speed N1 is associated with the value of the bus voltage V_{BUS}, the strictest condition with the minimum bus voltage V_{BUS} and the maximum output power is generally adopted for determining the value of the threshold rotational speed N1. The dynamically controlled minimum duty cycle curve MD1 may then be set to the maximum value MD_{MAX} in order to allow the low-side switch LSW to have sufficient turn-on time for the capacitor C1 to be sufficiently charged.

As previously stated, the levels and the frequencies of the output voltage V_{OUT} and the switching signal Vsw are determined by the rotational speed of the motor. When the rotational speed of the motor is between N1 and N2, the peaks of the output voltage V_{OUT} and the switching signal Vsw are the same. Under such circumstance, the frequency of the output voltage V_{OUT} increases, the required number of switching the low-side switch LSW decreases, and the value of the dynamically controlled minimum duty cycle curve MD1 may be set to decrease as the rotational speed of the motor increases. In the embodiment illustrated in FIG. 4, when the rotational speed of the motor is between N1 and N2, the value of the dynamically controlled minimum duty cycle curve MD1 decreases in a linear manner as the rotational speed of the motor increases. In another embodiment when the rotational speed of the motor is between N1 and N2, the value of the dynamically controlled minimum duty cycle curve MD1 decreases in a polynomial manner, an exponential manner or a stepwise manner as the rotational speed of the motor increases.

When the rotational speed of the motor is between 0 and N1 and between N1 and N2, the rising slope and the falling slope of the dynamically controlled minimum duty cycle curve MD1 may be determined according to the value of the bus voltage V_{BUS}, the value of the capacitor C1, the characteristic of the high-side switch HSW, the characteristic of the low-side switch LSW, the leakage current of the driving output circuit 20, and/or the PWM switching method of the high-side switch HSW and the low-side switch LSW. Since the value of the bus voltage V_{BUS} is proportional to the threshold rotational speed N1, the dynamically controlled minimum duty cycle curve MD1 may be determined according to the values of the bus voltage V_{BUS} in different applications. Since the leakage current of the driving output circuit 20 depletes the energy stored in the capacitor C1, the dynamically controlled minimum duty cycle curve MD1 may be determined according to the leakage current of the driving output circuit 20. Since a larger number of switching times results in larger switching loss and different modulation methods result in different energy consumption at the signal peaks, the dynamically controlled minimum duty cycle curve MD1 may be determined according to the PWM switching method of the high-side switch HSW and the low-side switch LSW.

When the rotational speed of the motor reaches N2, the required number of switching times of the low-side switch LSW is small enough so that the energy stored in the capacitor C1 is sufficient to maintain the operation of the high-side switch HSW. Under such circumstance, the dynamically controlled minimum duty cycle curve MD1 may be set to zero.

As depicted in FIG. 4, the prior art half-bridge bootstrap circuit controls the low-side switch according to a constant minimum duty cycle curve MD2, which also limits the maximum power of the motor (as depicted by the curve Po'). In contrast, the half-bridge bootstrap circuit 100 of the present invention adopts the dynamically controlled minimum duty cycle curve MD1 whose value is determined according to different operational phases of the motor, thereby capable of increasing the maximum power of the motor (as depicted by the curve Po). The amount of increase in the output power may be represented by the striped region between the curve Po and the curve Po' in Fig. 4.

In an embodiment of the present invention, each of the high-side switch HSW, the low-side switch LSW, and the switches SW1-SW4 may be a metal-oxide-semiconductor field-effect transistor (MOSFET), a bipolar junction transistors (BJT), or any other device having similar function. For N-type transistors, the enable level is logic 1, and the disable level is logic 0; for P-type transistors, the enable level is logic 0, and the disable level is logic 1.

In conclusion, the half-bridge bootstrap circuit of the present invention adopts the dynamically controlled minimum duty cycle curve for limiting the minimum turn-on time of the low-side switch, thereby ensuring that sufficient charges are stored in the boot capacitor for keeping the high-side switch turned on. Meanwhile, the value of the dynamically controlled minimum duty cycle curve is determined according to different operational phases of the motor, thereby capable of increasing the maximum power of the motor for driving the load.

## Claims

1. A method of dynamically controlling minimum duty cycle, comprising:
turning off a high-side switch (HSW) and turning on a low-side switch (LSW) during a charging period for allowing a direct-current, DC, voltage to charge a capacitor (C1) coupled between a direct-current, DC, voltage (V_{DC}) and an output end (N_{OUT});
turning on the high-side switch (HSW) and turning off the low-side switch (LSW) during a discharging period subsequent to the charging period for allowing energy stored in the capacitor (C1) to charge parasite capacitance (C_{PH}) between a
control end of the high-side switch (HSW) and a
second end of the high-side switch (HSW), thereby keeping the high-side switch (HSW) turned on and allowing a bus voltage (V_{BUS}) to be transmitted to the output end (N_{OUT}) for driving a motor; and
adjusting a first turn-on time of the high-side switch (HSW) during the discharging period according to a status of the output end (N_{OUT});
wherein the high-side switch (HSW) includes a first end coupled to the bus voltage (VBUS ) and a second end coupled to the output end (NOUT);
wherein the low-side switch (LSW) includes a first end coupled to the output end (NOUT ) and a second end coupled to a ground voltage (GND); **characterized by**
limiting a second turn-on time of the low-side switch (LSW) during the charging period according to a dynamically controlled minimum duty cycle curve, wherein:
a value of the dynamically controlled minimum duty cycle curve is not larger than a maximum value when a rotational speed of the motor is not larger than a first rotational speed;
wherein the value of the dynamically controlled minimum duty cycle curve is equal to the maximum value when the rotational speed of the motor is equal to the first rotational speed; and
wherein the value of the dynamically controlled minimum duty cycle curve is not larger than the maximum value when the rotational speed of the motor is greater than the first rotational speed.

2. The method of claim 1, **characterized in that** the value of the dynamically controlled minimum duty cycle curve increases as the rotational speed of the motor increases when the rotational speed of the motor is not larger than the first rotational speed.

3. The method of claim 2, **characterized in that** the value of the dynamically controlled minimum duty cycle curve increases in a linear manner, a polynomial manner, an exponential manner or a stepwise manner as the rotational speed of the motor increases when the rotational speed of the motor is not larger than the first rotational speed.

4. The method of any of claims 2-3, **further characterized by** comprising:
determining a rising slope of the dynamically controlled minimum duty cycle curve when the rotational speed of the motor is not larger than the first rotational speed according to a value of the bus voltage (V_{BUS}), a value of the capacitor (C1), a characteristic of the high-side switch (HSW), a characteristic of the low-side switch (LSW), a method of switching the high-side switch (HSW), and/or a method of switching the low-side switch (LSW).

5. The method of claim 1, **characterized in that** the value of the dynamically controlled minimum duty cycle curve decreases as the rotational speed of the motor increase when the rotational speed of the motor is larger than the first rotational speed.

6. The method of claim 5, **characterized in that** the value of the dynamically controlled minimum duty cycle curve decreases in a linear manner, a polynomial manner, an exponential manner or a stepwise manner as the rotational speed of the motor increases when the rotational speed of the motor is larger than the first rotational speed.

7. The method of any of claims 5-6, **further characterized by** comprising:
determining a falling slope of the dynamically controlled minimum duty cycle curve when the rotational speed of the motor is larger than the first rotational speed according to a value of the bus voltage (V_{BUS}), a value of the capacitor, a characteristic of the high-side switch (HSW), a characteristic of the low-side switch (LSW), a method of switching the high-side switch (HSW), and/or a method of switching the low-side switch (LSW).

8. The method of any of claims 1-7, **characterized in that**:
the value of the dynamically controlled minimum duty cycle curve is zero when the rotational speed of the motor is larger than a second rotational speed which is larger than the first rotational speed.

9. The method of any of claims 1-8, **further characterized by** comprising:
providing a switching signal (Vsw) having a constant frequency and a constant peak, wherein the constant frequency of the switching signal (Vsw) is larger than a frequency of an output voltage (V_{OUT}) established on the output end (N_{OUT});
turning off the high-side switch (HSW) and turning on the low-side switch (LSW) when a level of the switching signal (Vsw) is higher than a level of the output voltage (V_{OUT}); and
turning on the high-side switch (HSW) and turning off the low-side switch (LSW) when the level of the switching signal (Vsw) is lower than the level of the output voltage (V_{OUT}).

10. The method of any of claims 1-9, **characterized in that** the second turn-on time of the low-side switch (LSW) during the charging period is longer than or equal to a third turn-on time of the dynamically controlled minimum duty cycle curve.

11. A half-bridge bootstrap circuit (100) which dynamically controls minimum duty cycle, comprising:
an output end (N_{OUT}) for providing an output voltage (V_{OUT}) to drive a motor;
a high-side switch (HSW) configured to selectively conduct a signal path
between a bus voltage (V_{BUS}) and the output end (N_{OUT}) and comprising:
a first end coupled to the bus voltage (V_{BUS});
a second end coupled to the output end (N_{OUT}); and
a control end;
a low-side switch (LSW) configured to selectively conduct a signal path between the output end (N_{OUT}) and a ground voltage (GND) and comprising:
a first end coupled to the output end (N_{OUT});
a second end coupled to the ground voltage (GND); and
a control end;;
a capacitor (C1), including:
a first end coupled to a direct-current, DC, voltage (V_{DC}); and
a second end coupled to the output end (N_{OUT}); and
wherein a control circuit (30) is configured to turn off the high-side switch (HSW) and turn on the low-side switch (LSW) during a charging period for coupling the output end (NOUT) to the ground voltage (GND) and allowing the DC voltage to charge the capacitor (CI);
wherein the control circuit (30) is configured to turn on the high-side switch (HSW) and turn off the low-side switch (LSW) during a discharging period subsequent to the charging period for coupling the output end (NOUT) to the bus voltage (VBUS) and allowing energy stored in the capacitor (CI) to charge parasite capacitance (CPH) between the control end of the high-side switch (HSW) and the second end of the high-side switch (HSW), thereby keeping the high-side switch (HSW) turned on;
wherein the control circuit (30) is configured to adjust a first turn-on time of the high-side switch (HSW) during the discharging period according to a status of the output end (NOUT); and
**characterized in that** the control circuit (30) is configured to:
limit a second turn-on time of the low-side switch (LSW) during the charging period according to a dynamically controlled minimum duty cycle curve, wherein:
a value of the dynamically controlled minimum duty cycle curve is
not larger than a maximum value when a rotational speed of the motor is not larger than a first rotational speed;
wherein the value of the dynamically controlled minimum duty cycle curve is equal to the maximum value when the rotational speed of the motor is equal to the first rotational speed;
wherein the value of the dynamically controlled minimum duty cycle curve is not larger than the maximum value when the rotational speed of the motor is larger than a first rotational speed and smaller than a second rotational speed which is larger than the first rotational speed; and
wherein the value of the dynamically controlled minimum duty cycle curve is zero when the rotational speed of the motor is larger than the second rotational speed.

12. The half-bridge bootstrap circuit of claim 11, **characterized in that** the second turn-on time of the low-side switch (LSW) during the charging period is longer than or equal to a third turn-on time of the dynamically controlled minimum duty cycle curve.

## Patentansprüche

1. Verfahren zur dynamischen Steuerung einer minimalen Einschaltdauer, welches umfasst:
Ausschalten eines High-Side-Schalters (HSW) und Einschalten eines Low-Side-Schalters (LSW) während einer Ladeperiode, um Aufladen eines Kondensators (C1), der zwischen einer Gleichstromspannung (V_{DC}) und einem Ausgangsende (N_{OUT}) angeschlossen ist, mittels Gleichstrom zu ermöglichen,
Einschalten des High-Side-Schalters (HSW) und Ausschalten des Low-Side-Schalters (LSW) während einer Entladeperiode im Anschluss an die Ladeperiode, so dass die in dem Kondensator (C1) gespeicherte Energie eine parasitäre Kapazität (CPH) zwischen einem Steuerende des High-Side-Schalters (HSW) und einem zweiten Ende des High-Side-Schalters (HSW) aufladen kann, wodurch der High-Side-Schalter (HSW) eingeschaltet bleibt und ermöglicht wird, dass eine Busspannung (V_{BUS}) an das Ausgangsende (N_{OUT}) übertragen wird, um einen Motor zu betreiben; und
Einstellen einer ersten Einschaltzeit des High-Side-Schalters (HSW) während der Entladungsperiode gemäß einem Status des Ausgangsendes (N_{OUT});
wobei der High-Side-Schalter (HSW) ein erstes Ende, das mit der Busspannung (V_{BUS}) gekoppelt ist, und ein zweites Ende, das mit dem Ausgangsende (N_{OUT}) gekoppelt ist, umfasst;
wobei der Low-Side-Schalter (LSW) ein erstes Ende aufweist, das mit dem Ausgangsende (N_{OUT}) gekoppelt ist, und ein zweites Ende, das mit einer Massespannung (GND) gekoppelt ist;
**gekennzeichnet durch**
Beschränken einer zweiten Einschaltzeit des Low-Side-Schalters (LSW) während der Ladeperiode gemäß einer dynamisch gesteuerten minimalen Einschaltdauer-Kurve,
wobei ein Wert der dynamisch gesteuerten minimalen Einschaltdauer-Kurve nicht größer ist als ein Maximalwert, wenn eine Drehgeschwindigkeit des Motors nicht größer als eine erste Drehgeschwindigkeit ist;
wobei der Wert der dynamisch gesteuerten minimalen Einschaltdauer-Kurve gleich dem Maximalwert ist, wenn die Drehzahl des Motors gleich der ersten Drehzahl ist; und
wobei der Wert der dynamisch gesteuerten minimalen Einschaltdauer-Kurve nicht größer ist als der Maximalwert, wenn die Drehzahl des Motors größer als die erste Drehzahl ist.

2. Verfahren nach Anspruch 1, **dadurch gekennzeichnet, dass** der Wert der dynamisch gesteuerten minimalen Einschaltdauer-Kurve mit zunehmender Motordrehzahl ansteigt, wenn die Motordrehzahl nicht größer ist als die erste Motordrehzahl.

3. Verfahren nach Anspruch 2, **dadurch gekennzeichnet, dass** der Wert der dynamisch gesteuerten minimalen Einschaltdauer-Kurve linear, polynomial, exponentiell oder schrittweise ansteigt, wenn die Drehzahl des Motors ansteigt und die Drehzahl des Motors nicht größer ist als die erste Drehzahl.

4. Verfahren nach einem der Ansprüche 2 bis 3, weiter **dadurch gekennzeichnet, dass** es umfasst:
Bestimmen einer ansteigenden Steigung der dynamisch gesteuerten minimalen Einschaltdauer-Kurve gemäß einem Wert der Busspannung (V_{BUS}), einem Wert des Kondensators (C1), einer Charakteristik des High-Side-Schalters (HSW), einer Charakteristik des Low-Side-Schalters (LSW), einem Verfahren zum Schalten des High-Side-Schalters (HSW) und/oder einem Verfahren zum Schalten des Low-Side-Schalters (LSW), wenn die Drehzahl des Motors nicht größer ist als die erste Drehzahl.

5. Verfahren nach Anspruch 1, **dadurch gekennzeichnet, dass** der Wert der dynamisch gesteuerten minimalen Einschaltdauer-Kurve mit zunehmender Motordrehzahl abnimmt, wenn die Motordrehzahl größer als die erste Drehzahl ist.

6. Verfahren nach Anspruch 5, **dadurch gekennzeichnet, dass** der Wert der dynamisch gesteuerten minimalen Einschaltdauer-Kurve linear, polynomial, exponentiell oder schrittweise abnimmt, wenn die Drehzahl des Motors zunimmt, wenn die Drehzahl des Motors größer als die erste Drehzahl ist.

7. Verfahren nach einem der Ansprüche 5 bis 6, ferner **dadurch gekennzeichnet, dass** es umfasst:
Bestimmen einer abfallenden Steigung der dynamisch gesteuerten minimalen Einschaltdauer-Kurve gemäß einem Wert der Busspannung (VBUS), einem Wert des Kondensators, einer Charakteristik des High-Side-Schalters (HSW), einer Charakteristik des Low-Side-Schalters (LSW), einem Verfahren zum Schalten des High-Side-Schalters (HSW) und/oder einem Verfahren zum Schalten des Low-Side-Schalters (LSW), wenn die Drehzahl des Motors größer ist als die erste Drehzahl.

8. Verfahren nach einem der Ansprüche 1-7, **dadurch gekennzeichnet, dass**:
der Wert der dynamisch gesteuerten minimalen Einschaltdauer-Kurve Null ist, wenn die Drehzahl des Motors größer als eine zweite Drehzahl ist, die größer ist als die erste Drehzahl.

9. Verfahren nach einem der Ansprüche 1 bis 8, **dadurch gekennzeichnet, dass** es ferner Folgendes umfasst:
Bereitstellen eines Schaltsignals (VSW) mit einer konstanten Frequenz und einem konstanten Spitzenwert, wobei die konstante Frequenz des Schaltsignals (VSW) größer ist als eine Frequenz einer Ausgangsspannung (V_{OUT}), die an der Ausgangsseite (N_{OUT}) anliegt;
Ausschalten des High-Side-Schalters (HSW) und Einschalten des Low-Side-Schalters (LSW), wenn ein Niveau des Schaltsignals (VSW) höher ist als ein Niveau der Ausgangsspannung (V_{OUT}), und
Einschalten des High-Side-Schalters (HSW) und Ausschalten des Low-Side-Schalters (LSW), wenn das Niveau des Schaltsignals (VSW) niedriger ist als das Niveau der Ausgangsspannung (V_{OUT}).

10. Verfahren nach einem der Ansprüche 1 bis 9, **dadurch gekennzeichnet, dass** die zweite Einschaltzeit des Low-Side-Schalters (LSW) während der Ladeperiode länger als oder gleich einer dritten Einschaltzeit der dynamisch gesteuerten minimalen Einschaltdauer-Kurve ist.

11. Halbbrücken-Bootstrap-Schaltung (100), die eine minimale Einschaltdauer dynamisch steuert, umfassend:
eine Ausgangsseite (N_{OUT}) zum Bereitstellen einer Ausgangsspannung (V_{OUT}), um einen Motor anzutreiben;
einen High-Side-Schalter (HSW), der so konfiguriert ist, dass er selektiv einen Signalweg zwischen einer Busspannung (V_{BUS}) und dem Ausgangsende (N_{OUT}) leitet, und der Folgendes umfasst:
ein erstes Ende, das mit der Busspannung (V_{BUS}) gekoppelt ist;
ein zweites Ende, das mit dem Ausgangsende (N_{OUT}) gekoppelt ist; und
ein Steuerende;
einen Low-Side-Schalter (LSW), der so konfiguriert ist, dass er selektiv einen Signalpfad zwischen dem Ausgangsende (NouT) und einer Erdspannung (GND) leitet, und der Folgendes umfasst:
ein erstes Ende, das mit dem Ausgangsende (N_{OUT}) gekoppelt ist;
ein zweites Ende, das mit der Massespannung (GND) verbunden ist; und
ein Steuerende;
einen Kondensator (C1), der Folgendes umfasst:
ein erstes Ende, das mit einer Gleichspannung (VDC) verbunden ist; und
ein zweites Ende, das mit der Ausgangsseite (N_{OUT}) verbunden ist; und
wobei eine Steuerschaltung (30) so konfiguriert ist, dass sie den High-Side-Schalter (HSW) ausschaltet und den Low-Side-Schalter (LSW) während einer Ladeperiode einschaltet, um das Ausgangsende (N_{OUT}) mit der Massespannung (GND) zu koppeln, so dass der Kondensator (C1) mit der Gleichspannung geladen werden kann;
wobei die Steuerschaltung (30) so konfiguriert ist, dass sie den High-Side-Schalter (HSW) einschaltet und den Low-Side-Schalter (LSW) während einer Entladeperiode im Anschluss an die Ladeperiode ausschaltet, um das Ausgangsende (N_{OUT}) mit der Busspannung (V_{BUS}) zu koppeln und zu ermöglichen, dass in dem Kondensator (C1) gespeicherte Energie eine parasitäre Kapazität (CPH) zwischen dem Steuerende des High-Side-Schalters (HSW) und dem zweiten Ende des High-Side-Schalters (HSW) auflädt, wodurch der High-Side-Schalter (HSW) eingeschaltet bleibt;
wobei die Steuerschaltung (30) so konfiguriert ist, dass sie eine erste Einschaltzeit des High-Side-Schalters (HSW) während der Entladungsperiode entsprechend einem Status des Ausgangsendes (N_{OUT}) einstellt; und
**dadurch gekennzeichnet, dass** sie eine Steuerschaltung (30) umfasst, die konfiguriert ist, um:
eine zweite Einschaltzeit des Low-Side-Schalters (LSW) während der Ladeperiode gemäß einer dynamisch gesteuerten minimalen Einschaltdauer-Kurve zu begrenzen,
wobei ein Wert der dynamisch gesteuerten minimalen Einschaltdauer-Kurve nicht größer als ein Maximalwert ist, wenn eine Drehzahl des Motors nicht größer ist als eine erste Drehzahl;
wobei der Wert der dynamisch gesteuerten minimalen Einschaltdauer-Kurve gleich dem Maximalwert ist, wenn die Drehzahl des Motors gleich der ersten Drehzahl ist;
wobei der Wert der dynamisch gesteuerten minimalen Einschaltdauer-Kurve nicht größer ist als der Maximalwert, wenn die Drehzahl des Motors größer als eine erste Drehzahl und kleiner als eine zweite Drehzahl ist, die größer als die erste Drehzahl ist; und
wobei der Wert der dynamisch gesteuerten minimalen Einschaltdauer-Kurve Null ist, wenn die Drehzahl des Motors größer als die zweite Drehzahl ist.

12. Halbbrücken-Bootstrap-Schaltung nach Anspruch 11, **dadurch gekennzeichnet, dass** die zweite Einschaltzeit des Low-Side-Schalters (LSW) während der Ladeperiode länger als oder gleich einer dritten Einschaltzeit der dynamisch gesteuerten minimalen Einschaltdauer-Kurve ist.

## Revendications

1. Procédé de commande dynamique du rapport cyclique minimum, comprenant les étapes:
la mise hors circuit d'un commutateur côté haut (HSW) et la mise en circuit d'un commutateur côté bas (LSW) pendant une période de charge pour permettre à une tension continue de charger un condensateur (C1) couplé entre une tension continue (VDC) et une extrémité de sortie (N_{OUT});
activer l'interrupteur côté haut (HSW) et désactiver l'interrupteur côté bas (LSW) pendant une période de décharge suivant la période de charge pour permettre à l'énergie stockée dans le condensateur (C1) de charger la capacité parasite (CPH) entre une extrémité de commande de l'interrupteur côté haut (HSW) et une seconde extrémité de l'interrupteur côté haut (HSW), maintenant ainsi l'interrupteur côté haut (HSW) activé et permettant à une tension de bus (V_{BUS}) d'être transmise à l'extrémité de sortie (N_{OUT}) pour entraîner un moteur; et
ajuster un premier temps d'activation de l'interrupteur côté haut (HSW) pendant la période de décharge en fonction d'un état de l'extrémité de sortie (N_{OUT}) ;
dans lequel le commutateur côté haut (HSW) comprend une première extrémité couplée à la tension de bus (V_{BUS}) et une seconde extrémité couplée à l'extrémité de sortie (N_{OUT});
dans lequel le commutateur côté bas (LSW) comprend une première extrémité couplée à l'extrémité de sortie (N_{OUT}) et une seconde extrémité couplée à une tension de masse (GND);
**caractérisé par**
la limitation d'un deuxième temps d'activation du commutateur côté bas (LSW) pendant la période de charge selon une courbe de rapport cyclique minimum contrôlée dynamiquement,
dans lequel une valeur de la courbe de rapport cyclique minimale commandée dynamiquement n'est pas supérieure à une valeur maximale lorsqu'une vitesse de rotation du moteur n'est pas supérieure à une première vitesse de rotation;
dans lequel la valeur de la courbe du rapport cyclique minimum commandé dynamiquement est égale à la valeur maximum lorsque la vitesse de rotation du moteur est égale à la première vitesse de rotation ; et
dans lequel la valeur de la courbe du rapport cyclique minimum commandé dynamiquement n'est pas supérieure à la valeur maximum lorsque la vitesse de rotation du moteur est supérieure à la première vitesse de rotation.

2. Procédé de la revendication 1, **caractérisé en ce que** la valeur de la courbe du rapport cyclique minimum commandé dynamiquement augmente lorsque la vitesse de rotation du moteur augmente lorsque la vitesse de rotation du moteur n'est pas supérieure à la première vitesse de rotation.

3. Procédé de la revendication 2, **caractérisé en ce que** la valeur de la courbe du rapport cyclique minimum contrôlé dynamiquement augmente de manière linéaire, de manière polynomiale, de manière exponentielle ou de manière échelonnée lorsque la vitesse de rotation du moteur augmente lorsque la vitesse de rotation du moteur n'est pas supérieure à la première vitesse de rotation.

4. Le procédé de l'une quelconque des revendications 2-3, **caractérisé en outre en ce qu'**il comprend :
la détermination d'une pente ascendante de la courbe de rapport cyclique minimum contrôlée dynamiquement lorsque la vitesse de rotation du moteur n'est pas supérieure à la première vitesse de rotation en fonction d'une valeur de la tension de bus (V_{BUS}), d'une valeur du condensateur (C1), d'une caractéristique du commutateur côté haut (HSW), d'une caractéristique du commutateur côté bas (LSW), d'un procédé de commutation du commutateur côté haut (HSW), et/ou d'un procédé de commutation du commutateur côté bas (LSW).

5. Le procédé de la revendication 1, **caractérisé en ce que** la valeur de la courbe de rapport cyclique minimale contrôlée dynamiquement diminue lorsque la vitesse de rotation du moteur augmente lorsque la vitesse de rotation du moteur est supérieure à la première vitesse de rotation.

6. Procédé selon la revendication 5, **caractérisé en ce que** la valeur de la courbe du rapport cyclique minimum commandé dynamiquement diminue de manière linéaire, polynomiale, exponentielle ou par paliers lorsque la vitesse de rotation du moteur augmente lorsque la vitesse de rotation du moteur est supérieure à la première vitesse de rotation.

7. Le procédé de l'une quelconque des revendications 5 à 6, **caractérisé en outre en ce qu'**il comprend :
la détermination d'une pente descendante de la courbe de rapport cyclique minimum contrôlée dynamiquement lorsque la vitesse de rotation du moteur est supérieure à la première vitesse de rotation en fonction d'une valeur de la tension de bus (V_{BUS}), d'une valeur du condensateur, d'une caractéristique du commutateur côté haut (HSW), d'une caractéristique du commutateur côté bas (LSW), d'un procédé de commutation du commutateur côté haut (HSW) et/ou d'un procédé de commutation du commutateur côté bas (LSW).

8. Procédé de l'une quelconque des revendications 1 à 7, **caractérisé en ce que** :
la valeur de la courbe de rapport cyclique minimum à commande dynamique est nulle lorsque la vitesse de rotation du moteur est supérieure à une deuxième vitesse de rotation qui est supérieure à la première vitesse de rotation.

9. Procédé de l'une quelconque des revendications 1 à 8, **caractérisé en outre en ce qu'**il comprend:
la fourniture d'un signal de commutation (VSW) ayant une fréquence constante et un pic constant, dans lequel la fréquence constante du signal de commutation (VSW) est supérieure à une fréquence d'une tension de sortie (V_{OUT}) établie sur l'extrémité de sortie (N_{OUT});
désactiver l'interrupteur côté haut (HSW) et activer l'interrupteur côté bas (LSW) lorsqu'un niveau du signal de commutation (VSW) est supérieur à un niveau de la tension de sortie (V_{OUT}); et
activer le commutateur côté haut (HSW) et désactiver le commutateur côté bas (LSW) lorsque le niveau du signal de commutation (VSW) est inférieur au niveau de la tension de sortie (V_{OUT}).

10. Procédé de l'une quelconque des revendications 1 à 9, **caractérisé en ce que** le deuxième temps d'activation de l'interrupteur côté bas (LSW) pendant la période de charge est plus long ou égal à un troisième temps d'activation de la courbe de rapport cyclique minimale contrôlée dynamiquement.

11. Circuit d'amorçage en demi-pont (100) qui commande dynamiquement le rapport cyclique minimum, comprenant :
une extrémité de sortie (N_{OUT}) pour fournir une tension de sortie (V_{OUT}) pour piloter un moteur ;
un commutateur côté haut (HSW) configuré pour conduire sélectivement un chemin de signal entre une tension de bus (V_{BUS}) et l'extrémité de sortie (N_{OUT}) et comprenant :
une première extrémité couplée à la tension de bus (V_{BUS}) ;
une seconde extrémité couplée à l'extrémité de sortie (N_{OUT}) ; et
une extrémité de commande;
un commutateur côté bas (LSW) configuré pour conduire sélectivement un chemin de signal entre l'extrémité de sortie (N_{OUT}) et une tension de masse (GND) et comprenant :
une première extrémité couplée à l'extrémité de sortie (N_{OUT}) ;
une deuxième extrémité couplée à la tension de masse (GND) ; et
une extrémité de commande ; ;
un condensateur (C1), comprenant
une première extrémité couplée à une tension continue (VDC) ; et
une seconde extrémité couplée à l'extrémité de sortie (N_{OUT}) ; et
dans lequel un circuit de commande (30) est configuré pour désactiver le commutateur côté haut (HSW) et activer le commutateur côté bas (LSW) pendant une période de charge pour coupler l'extrémité de sortie (N_{OUT}) à la tension de masse (GND) et permettre à la tension continue de charger le condensateur (C1) ;
dans lequel le circuit de commande (30) est configuré pour activer l'interrupteur côté haut (HSW) et désactiver l'interrupteur côté bas (LSW) pendant une période de décharge suivant la période de charge pour coupler l'extrémité de sortie (N_{OUT}) à la tension de bus (V_{BUS}) et permettre à l'énergie stockée dans le condensateur (C1) de charger la capacité parasite (CPH) entre l'extrémité de commande de l'interrupteur côté haut (HSW) et la seconde extrémité de l'interrupteur côté haut (HSW), maintenant ainsi l'interrupteur côté haut (HSW) activé ;
dans lequel le circuit de commande (30) est configuré pour ajuster un premier temps de mise en marche de l'interrupteur côté haut (HSW) pendant la période de décharge selon un état de l'extrémité de sortie (N_{OUT}) ; et
**caractérisé en ce qu'**il comprend un circuit de commande (30) configuré pour :
limiter un deuxième temps d'activation du commutateur côté bas (LSW) pendant la période de charge selon une courbe de rapport cyclique minimum commandée dynamiquement,
dans lequel une valeur de la courbe de rapport cyclique minimale commandée dynamiquement n'est pas supérieure à une valeur maximale lorsqu'une vitesse de rotation du moteur n'est pas supérieure à une première vitesse de rotation ;
dans lequel la valeur de la courbe du rapport cyclique minimum commandé dynamiquement est égale à la valeur maximum lorsque la vitesse de rotation du moteur est égale à la première vitesse de rotation ;
dans lequel la valeur de la courbe du rapport cyclique minimum commandé dynamiquement n'est pas supérieure à la valeur maximum lorsque la vitesse de rotation du moteur est supérieure à une première vitesse de rotation et inférieure à une seconde vitesse de rotation qui est supérieure à la première vitesse de rotation ; et
dans lequel la valeur de la courbe du rapport cyclique minimum commandé dynamiquement est nulle lorsque la vitesse de rotation du moteur est supérieure à la seconde vitesse de rotation.

12. Le circuit d'amorçage en demi-pont de la revendication 11, **caractérisé en ce que** le deuxième temps d'activation du commutateur côté bas (LSW) pendant la période de charge est plus long ou égal à un troisième temps d'activation de la courbe de rapport cyclique minimum contrôlée dynamiquement.
